(19) Europäisches Patentamt
European Patent Office
Office européen des brevets

(11) **EP 0 949 760 A1**

(12) **EUROPEAN PATENT APPLICATION**

(43) Date of publication:
**13.10.1999 Bulletin 1999/41**

(51) Int Cl.⁶: **H03K 5/13**

(21) Application number: **99106058.3**

(22) Date of filing: **25.03.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **26.03.1998 JP 7878898**

(71) Applicant: **Sanyo Electric Co., Ltd.**
**Moriguchi-shi, Osaka 570-8677 (JP)**

(72) Inventors:
• **Kiyose, Masashi**
**Gifu-shi, Gifu-ken 500-8365 (JP)**
• **Akiyama, Toru**
**Motosu-gun, Gifu-ken 501-0234 (JP)**

(74) Representative: **Geyer, Werner, Dr.-Ing. et al**
**Patentanwälte**
**Geyer, Fehners & Partner**
**Perhamerstrasse 31**
**80687 München (DE)**

(54) **Pulse delay circuit with variable delay time**

(57) A pulse delay circuit includes a voltage-controlled oscillator (VCO) (4), a phase comparator (7), a low pass filter (8) and a delay line (2). The VCO (4) includes a plurality of first delay elements (50, 51) connected in a loop shape and generates an oscillation output signal according to a control voltage. The phase comparator (7) receives the oscillation output signal and a reference signal, compares the phase of the oscillation output signal and the phase of the reference signal, and generates a comparison signal indicating a phase difference therebetween. The low pass filter (8) receives the comparison signal and generates the control voltage. The delay line (2) includes a plurality of series connected second delay elements (60) for delaying a clock signal and generating a plurality of delay clock signals. Each of the second delay elements (60) is substantially identical to the first delay elements (50, 51). Each of the first and second delay elements (50, 51, 60) sets its own delay time in accordance with the control voltage.

**Fig.1**

# Description

## TECHNICAL FIELD

The present invention generally relates to a pulse signal delay circuit including a plurality of delay-elements, and, more particularly, to a pulse signal delay circuit with a controllable delay time.

## RELATED BACKGROUND ART

In general, a pulse signal delay circuit includes a plurality of delay elements connected in series. In a CMOS semiconductor device, a delay element is formed by an inverter having a P-channel MOS transistor and an N-channel MOS transistor. A comparator may be used instead of the inverter. A selector is connected to the delay elements and selects one of the delay outputs from the plurality of delay elements. A controllable range or a resolution of the delay time is determined by the numbers of the delay elements.

In a conventional delay circuit, the delay time is affected by the characteristics of each of the delay elements. However, it is impossible to use delay elements having identical characteristics because there is some scattering during manufacturing. Due to this scattering, it is difficult to precisely set or control the delay time in psec order. To maintain the delay time of a respective delay element or the delay circuit, an external circuit may be used. Alternatively, an adjustment could be employed to the delay circuit when manufacturing. In addition, the characteristics of the delay elements also varies in accordance with fluctuations of a supply voltage and temperature, resulting in further fluctuating the delay time of the delay elements. Once the delay circuit is manufactured, an alternation of the delay time is achieved only when the numbers of the delay elements is changed.

It is an object of the present invention to provide a pulse signal delay circuit with a precisely controllable delay time over wide range.

## DISCLOSURE OF THE INVENTION

In one aspect of the present invention, a pulse delay circuit includes a voltage-controlled oscillator (VCO), a phase comparator, a low pass filter and a delay line. The VCO includes a plurality of first delay elements connected in a ring shape and generates an oscillation output signal according to a control voltage. The phase comparator receives a reference signal one of the oscillation output signal and a frequency-divided oscillation output signal, compares the phase of the reference signal and the phase of one of the oscillation output signal and the frequency-divided oscillation output signal, and generates a comparison signal indicating a phase difference therebetween. The low pass filter receives the comparison signal and generates the control voltage. The delay line includes a plurality of series connected second delay elements for delaying a clock signal and generating a plurality of delay clock signals. Each of the second delay elements is substantially identical to the first delay elements. Each of the first and second delay elements sets its own delay time in accordance with the control voltage.

Other aspects and advantages of the invention will become apparent from the following description, taken in conjunction with the accompanying drawings, illustrating by way of example the principles of the invention.

## BRIEF DESCRIPTION OF THE DRAWINGS

The invention, together with objects and advantages thereof, may best be understood by reference to the following description of the presently preferred embodiments together with the accompanying drawings in which:

Fig. 1 is a block diagram of a delay circuit according to a first embodiment of the present invention;
Fig. 2 is a circuit diagram of a delay cell of the delay circuit of Fig. 1;
Fig. 3 is a timing chart describing the operation of a VCO of the delay circuit of Fig. 1; and
Fig. 4 (a) is a graph showing VCO characteristics and Fig. 4 (b) is a graph showing delay characteristics.

## DESCRIPTION OF SPECIAL EMBODIMENT

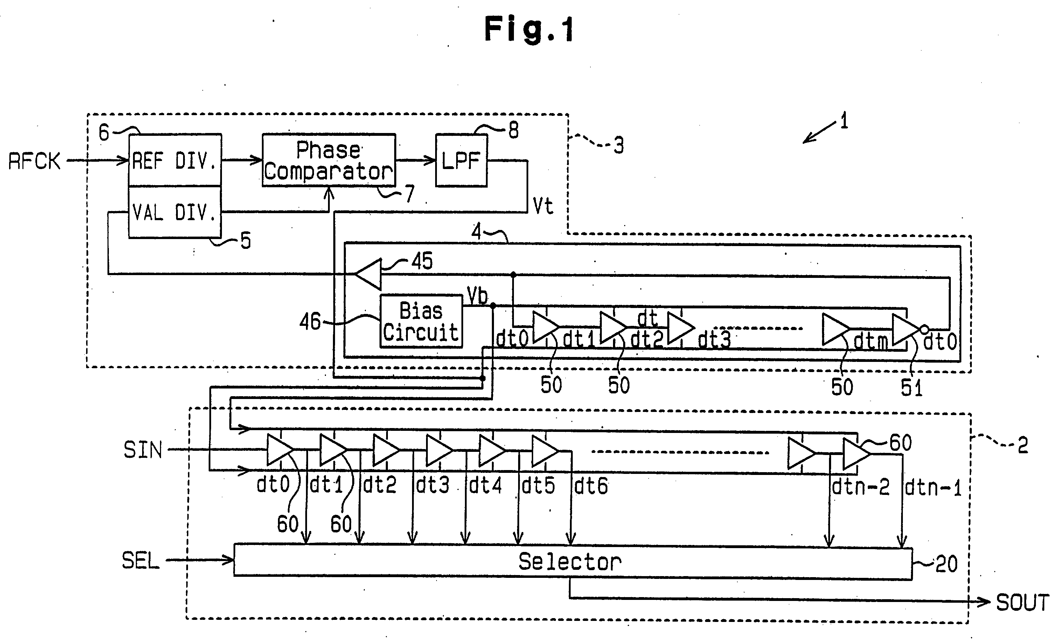

Fig. 1 is a block diagram of a delay circuit 1 suitable for obtaining a highly accurate and substantially uniform delay time. The delay circuit 1 includes a delay line 2 for generating a delay input signal and a PLL circuit 3 for controlling the delay time of the delay line 2. The delay line 2 includes a selector 20.

The PLL circuit 3 includes a voltage-controlled oscillator (VCO) 4, a programmable divider 5, a reference divider 6, a phase comparator 7, and a low pass filter 8. The VCO 4 generates an oscillation output signal having a frequency that varies in accordance with a control voltage Vt. The programmable divider 5 frequency-divides the oscillation output signal of the VCO 4 into 1/N and generates a frequency-divided oscillation output signal. The reference divider 6 frequency-divides a reference signal RFCK into 1/M and generates a frequency-divided reference signal. The phase comparator 7 compares the phase of the frequency-divided oscillation output signal and the phase of the frequency-divided reference signal and generates a phase difference detection signal. The low pass filter 8 supplies the control voltage Vt according to the phase difference detection signal to the VCO 4. The frequency division ratio of the programmable divider 5 and the reference divider 6 is changeable. A charge pump (not illustrated) is provided between the phase comparator 7 and the LPF 8.

The VCO 4 includes a plurality of delay cells 50 and 51 connected in series and has a ring or loop shaped configuration in which the output of the final-stage delay cell 51 is negatively fed back to the initial-stage delay cell 50. The output signal of the final-stage delay cell 51 is supplied to the programmable divider 5 via a buffer 45. A predetermined bias voltage Vb is supplied from a bias circuit 46 to the first control terminal, and the control voltage Vt from the low pass filter 8 is supplied to the second control terminal.

The delay line 2 includes a plurality of delay cells 60 connected in series. Each delay cell 60 has the same configuration as the delay cell 50. The first-stage delay cell 60 receives an input signal SIN supplied from an external device (not illustrated). The selector 20 selects any one of the delay output signals from a plural of the delay cells 60 and outputs a delay signal SOUT. The delay cells 50 and 51 of the VCO 4 and the delay cells 60 of the delay line 2 are arranged to be in close proximity. The delay characteristics of the delay cells 50, 51, and 60 are substantially the same.

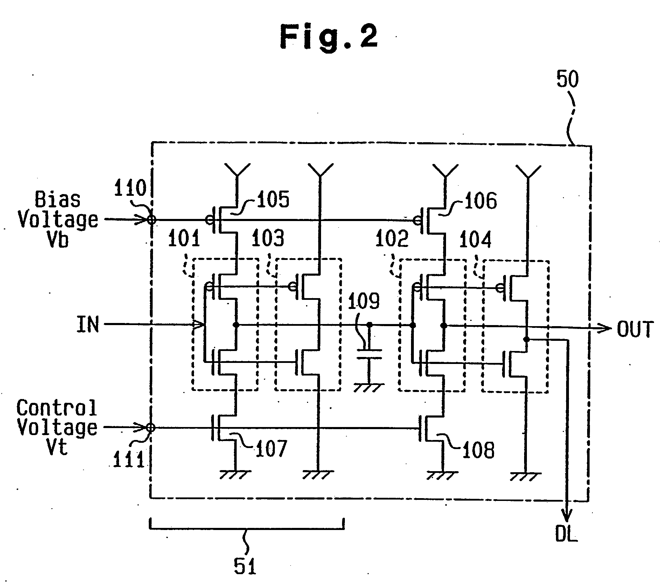

Fig. 2 is a circuit diagram of the delay cell 50. The delay cell 50 includes first and second inverters 101 and 102 connected in series and first and second buffers 103 and 104 connected to the first and second inverters 101 and 102, respectively. Each of the first and second inverters 101 and 102 includes a P-channel MOS transistor and an N-channel MOS transistor that are connected in series. Current-controlled P-channel MOS transistors 105 and 106 are connected between a power potential and the first and second inverters 101 and 102, respectively. Current-controlled N-channel MOS transistors 107 and 108 are connected between a ground potential and the first and second inverters 101 and 102, respectively. The gate of the current-controlled N-channel MOS transistor 105 is connected to a first control terminal 110, and the gate of the current-controlled N-channel MOS transistor 107 is connected to a second control terminal 111. A parasitic capacitor 109 is connected between the ground potential and a node between the first and second inverters 101 and 102.

The predetermined bias voltage Vb from the bias circuit 46 is applied to the first control terminal 110, and the control voltage Vt from the low pass filter 8 is applied to the second control terminal 111. When the control voltage Vt increases, the current flowing in the inverters 101 and 102 increases and a delay time dt of an input signal IN decreases. When the control voltage Vt decreases, the current flowing in the first and second inverters 101 and 102 decreases and the delay time dt of the input signal IN increases. The delay time dt of the delay cell 50 varies in accordance with the control voltage Vt.

The final-stage delay cell 51 includes only the first inverter 101, the first buffer 103, and the current-controlled P-channel and N-channel MOS transistors 105 and 107. Accordingly, the output signal of the first inverter 101 of the final-stage delay cell 51 is fed back to the input of the first inverter 101 of the first-stage delay cell 50.

Next, the operation of the delay circuit 1 will be described. A frequency fl of the oscillation output signal of the VCO 4 is frequency-divided into f1/N by the programmable divider 5, and a frequency f0 of the reference signal is frequency-divided into f0/M by the reference divider 6. The phases of two frequency division signals are compared by the phase comparator 7, and the control voltage Vt according to the phase difference is supplied from the low pass filter 8 to the VCO 4. The PLL circuit 3 operates such that the phase difference of the frequency division signals from the dividers 5 and 6 disappears. When the PLL circuit 3 is locked, the following equation (1) is established.

$$f1/N = f0/M \qquad (1)$$

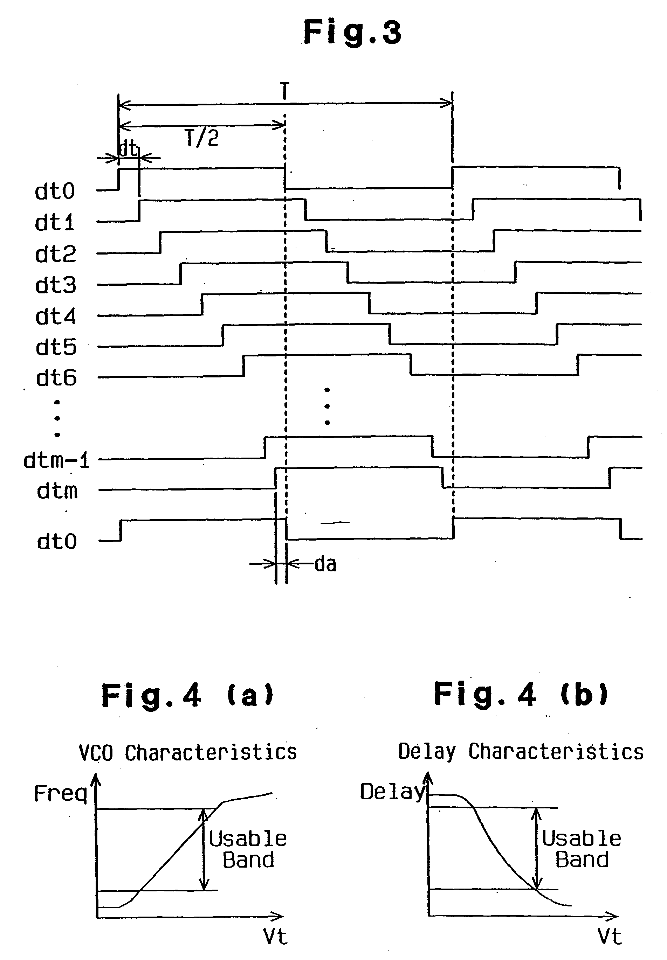

The delay time dt of each delay cell 50 is determined in accordance with the control voltage Vt. As shown in Fig. 3, a signal dt0 supplied to the initial-stage delay cell 50 is delayed by the delay time dt while it is passing through each latter-stage delay cell 50. The output signal of the initial-stage delay cell 50 is reversed by the final-stage delay cell 51, and the resulting inverse signal is delayed by loopback delay $d\alpha$ and fed back to the first-stage delay cell 50. When the loopback delay da is far smaller than the delay time dt, the delay time dt is represented by the following equation (2).

$$T/2 = dt \cdot D \qquad (2)$$

That is, the value obtained by adding the delay time dt by the number of stages D of the delay cells 50 is substantially equal to the semi-cycle T/2 of the VCO 4 cycle T.

When the PLL circuit 3 is locked, the delay time dt is represented by the following equation (3) based on the cycle T =1/f1 and the aforementioned equation (1).

$$dt = (M/N) \cdot (1/2D \cdot f0) \qquad (3)$$

When the number of stages D of the delay cells 50 and 51 and the frequency division ratios M and N are determined, the delay time dt of the delay cells 50 is set to a constant value that depends on only the frequency f0 of the reference signal RFCK.

The delay cell 60 of the delay line 2 has the same configuration as the delay cell 50 of the VCO 4, and the same control voltage Vt is supplied to the delay cells 50 and 60. Accordingly, the delay time of the delay cells 50 and 60 is substantially the same.

The input signal SIN is sequentially delayed by the delay cell 60, and the single delay output SOUT is selected using the selector 20. When the PLL circuit 3 is locked, the delay time dt of each delay cell 60 is set to a constant value so that a delay signal delayed by a constant delay time is output from the selector 20. This eliminates the need for adjusting the delay line 2 during manufacture and allows the delay time to be set with the guaranteed accuracy of the PLL circuit 3. As a result, a highly accurate delay time is set in psec order. Moreover, the PLL circuit 3 is also hardly affected by power fluctuation and temperature fluctuation, and so the delay time of the delay line 2 is also hardly affected by these fluctuations.

The delay time dt is easily changed in accordance with the frequency f0 of the reference signal RFCK and the frequency division ratios M and N. This facilitates the setting of the resolution of the delay line 2. For example, when the number of stages D of the delay cell 50 is set to "16", each of the frequency division ratios M and N is set to "2", and f0 is set to "17.28 MHz", then the delay time dt "1.81 nsec" is obtained from the aforementioned equation (3). When each frequency division ratio is set to "4" and f0 is set to "34.56 MHz", the delay time dt "0.90 nsec" is obtained. In this case, the resolution of the delay line 2 is in psec order.

Fig. 10 (a) is a graph showing characteristics of the VCO 4, and Fig. 10 (b) is a graph showing delay characteristics. The frequency range in which the PLL 3 is locked is relatively wide, and the delay time dt of the delay cells can be set within the frequency range. Accordingly, the delay time setting range of the delay line 2 is wide.

It should be apparent to those skilled in the art that the present invention may be embodied in many other specific forms without departing from the spirit or scope of the invention. Particularly, it should be understood that the invention may be embodied in the following forms.

Comparators may be used instead of the inverters 101 and 102 of the delay cells 50, 51, and 60. Further, the control voltage Vt from the low pass filter 8 may be supplied to the current-controlled transistors 105 to 108.

The present examples and embodiments are to be considered as illustrative and not restrictive and the invention is not to be limited to the details given herein, but may be modified within the scope and equivalence of the appended claims.

## Claims

1. A pulse delay circuit characterized by:

   a voltage-controlled oscillator (VCO) (4) including a plurality of first delay elements (50, 51) connected in a ring shape and generating an oscillation output signal according to a control voltage;

   a phase comparator (7) for receiving a reference signal one of the oscillation output signal and a frequency-divided oscillation output signal, comparing the phase of the reference signal and the phase of one of the oscillation output signal and the frequency-divided oscillation output signal, and generating a comparison signal indicating a phase difference therebetween; a low pass filter (8) for receiving the comparison signal and generating the control voltage; and a delay line (2) including a plurality of series connected second delay elements (60) for delaying a clock signal and generating a plurality of delay clock signals, each of the second delay elements (60) being substantially identical to the first delay elements (50, 51), wherein each of the first and second delay elements (50, 51, 60) sets its own delay time in accordance with the control voltage.

2. The circuit of claim 1, wherein each of the first and second delay elements (50, 51, 60) includes a transistor for controlling a current flowing therethrough in accordance with the control voltage.

3. The circuit of claim 1, wherein the delay line (2) includes a selector connected to the plurality of second delay elements (60), for selecting one of the plurality of delay clock signals in accordance with an associated selection signal.

4. The circuit of claim 1, wherein each of the plurality of first and second delay elements is an inverter (50, 51, 60).

5. The circuit of claim 4, wherein each of the inverters operates by receiving a predetermined bias voltage and the control voltage from the low pass filter (8).

6. The circuit of claim 1, wherein each of the plurality of first and second delay elements (50, 51, 60) is a comparator.

# Fig.1

EP 0 949 760 A1

# Fig.2

# Fig.3

# Fig.4 (a)

VCO Characteristics

# Fig.4 (b)

Delay Characteristics

# EP 0 949 760 A1

**European Patent Office**

## EUROPEAN SEARCH REPORT

Application Number

EP 99 10 6058

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 4 703 251 A (BAUMGARTNER RICHARD A ET AL) 27 October 1987 <br> * column 11, line 36 - column 12, line 37; figures 17,18 * <br> * column 4, line 11-32; figure 4 * | 1-5 | H03K5/13 |
| Y | | 6 | |
| Y | EP 0 087 707 A (HEWLETT PACKARD CO) 7 September 1983 <br> * figure 1 * | 6 | |
| X | US 5 428 309 A (YAMAUCHI NAOKI ET AL) 27 June 1995 <br> * column 3, line 12-53; figure 1 * | 1,3-5 | |
| X | EP 0 395 118 A (YAMAHA CORP) 31 October 1990 <br> * page 5, line 10-39; figures 16,17 * | 1,2,4,5 | |
| X | EP 0 306 662 A (TEKTRONIX INC) 15 March 1989 <br> * column 7, line 29 - column 8, line 40; figures 3,5-7 * | 1-3 | TECHNICAL FIELDS SEARCHED (Int.Cl.6) <br><br> H03K |
| A | US 5 677 650 A (ILIASEVITCH STEPHAN ET AL) 14 October 1997 <br> * figure 3A * | 5 | |

The present search report has been drawn up for all claims

| Place of search | Date of completion of the search | Examiner |
|---|---|---|
| MUNICH | 24 June 1999 | Moll, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)

8

**ANNEX TO THE EUROPEAN SEARCH REPORT
ON EUROPEAN PATENT APPLICATION NO.**

EP 99 10 6058

This annex lists the patent family members relating to the patent documents cited in the above-mentioned European search report.
The members are as contained in the European Patent Office EDP file on
The European Patent Office is in no way liable for these particulars which are merely given for the purpose of information.

24-06-1999

| Patent document cited in search report | | Publication date | Patent family member(s) | | Publication date |
|---|---|---|---|---|---|
| US 4703251 | A | 27-10-1987 | US | 4638191 A | 20-01-1987 |
| | | | DE | 3585706 A | 30-04-1992 |
| | | | EP | 0167157 A | 08-01-1986 |
| | | | HK | 54593 A | 11-06-1993 |
| | | | JP | 2639390 B | 13-08-1997 |
| | | | JP | 61043811 A | 03-03-1986 |
| EP 0087707 | A | 07-09-1983 | JP | 58184817 A | 28-10-1983 |
| US 5428309 | A | 27-06-1995 | JP | 2296410 A | 07-12-1990 |
| EP 0395118 | A | 31-10-1990 | JP | 61039721 A | 25-02-1986 |
| | | | JP | 61039722 A | 25-02-1986 |
| | | | JP | 1768017 C | 11-06-1993 |
| | | | JP | 4051909 B | 20-08-1992 |
| | | | JP | 61039976 A | 26-02-1986 |
| | | | JP | 61144772 A | 02-07-1986 |
| | | | JP | 2015834 C | 19-02-1996 |
| | | | JP | 7032342 B | 10-04-1995 |
| | | | JP | 61147614 A | 05-07-1986 |
| | | | EP | 0171022 A | 12-02-1986 |
| | | | EP | 0390226 A | 03-10-1990 |
| | | | US | 5012141 A | 30-04-1991 |
| | | | US | 5039893 A | 13-08-1991 |
| | | | US | 4956720 A | 11-09-1990 |
| EP 0306662 | A | 15-03-1989 | US | 4833695 A | 23-05-1989 |
| | | | DE | 3874261 A | 08-10-1992 |
| | | | JP | 1072641 A | 17-03-1989 |
| | | | JP | 1911413 C | 09-03-1995 |
| | | | JP | 6042664 B | 01-06-1994 |
| US 5677650 | A | 14-10-1997 | CA | 2179236 A | 20-06-1997 |

EPO FORM P0459

For more details about this annex : see Official Journal of the European Patent Office, No. 12/82